# EUROPEAN PATENT APPLICATION

(11) **EP 1 432 239 A1**
(43) Date of publication of application: **23.06.2004**
(21) Application number: 03029315.3
(22) Date of filing: 18.12.2003
(51) Int. Cl.: H04N 5/225

(54) **Camera module**

(30) Priority: 18.12.2002 JP 2002366275
(71) Applicant: Sanyo Electric Co., Ltd., Moriguchi-shi, Osaka 570-8677 (JP)
(72) Inventor: IKEDA, Osamu, Ora-gun, Gunma (JP)
(74) Representative: Glawe, Delfs, Moll & Partner

(57) **Abstract**

A camera module for mobile device is reduced in size and production cost. CCDs, which are photoelectronic transducers, are formed in a surface of a semiconductor chip (60) composing an image sensor (61), and an IR filter (90) is bonded with an adhesive to cover the surface of the semiconductor chip (60). The IR filter (90) has a filtering function in addition to a function to support the semiconductor chip (60). The IR filter (90) is obtained by vacuum deposition of metal on a glass material or incorporating copper particles into a glass material, and implements both filtering function and chip-supporting function.

## Description

### BACKGROUND OF THE INVENTION

### Field of the Invention

This invention relates to a camera module, specifically to a small size camera module suitable to be incorporated into a portable device such as a mobile phone.

### Description of the Related Art

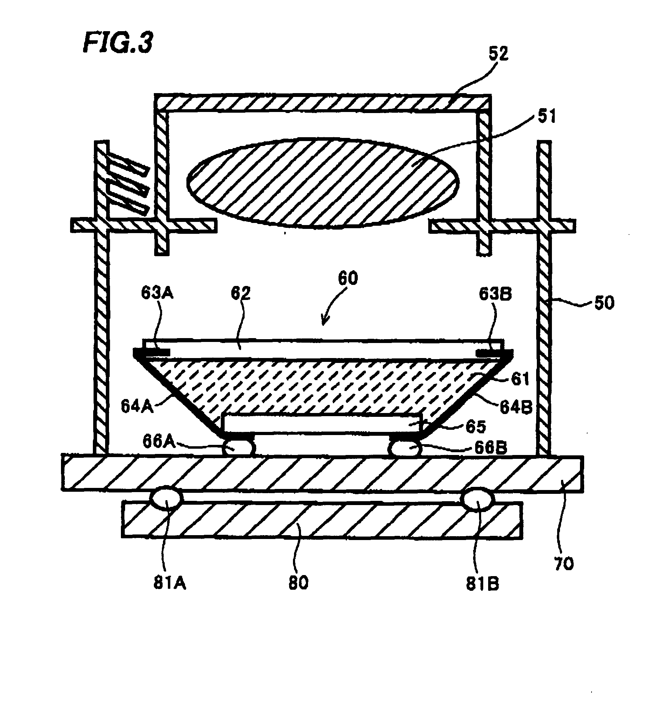

A mobile phone with camera function has come into widespread use in recent years. This type of mobile phone incorporates a small size camera module. Fig. 3 is a cross-sectional view showing a structure of such a camera module.

Fig. 3 shows a lens-barrel 50, a lens 51 mounted inside the lens-barrel 50 and an IR filter 52 attached to a mouth of the lens-barrel 50 to block infrared radiation. It also shows an image sensor chip 60 housed in a space within the lens-barrel 50 and electrically connected with a printed circuit board 70.

The image sensor chip 60 converts light incident from a photogenic subject through the IR filter 52 and the lens 51 into electric signals. In the image sensor chip 60, a supporting glass substrate 62 is bonded to a thin silicon chip 61, in a surface of which CCDs (Charge Coupled Devices) are formed.

Each of redistribution wirings 64A and 64B is formed to extend from each of electrode pads 63A and 63B, which are formed on a peripheral surface of the image sensor chip 60, over a side surface and to a back surface of the silicon chip 61. Each of the redistribution wirings 64A and 64B extends onto a glass substrate 65 which is bonded to the back surface of the silicon chip 61. Each of bump electrodes 66A and 66B is formed on an end of each of the redistribution wirings 64A and 64B extended onto the glass substrate 65. The bump electrodes 66A and 66B are connected to the printed circuit board 70.

A DSP (Digital Signal Processor) 80, which performs video signal processing on the electric signals from the image sensor chip 60, is connected to a back surface of the printed circuit board 70 through bump electrodes 81A and 81B.

In the camera module described above, the lens-barrel 50, the lens 51, the IR filter 52 and the image sensor chip 60 are discrete components, and the camera module is assembled by putting these discrete components together. This causes difficulty in reducing the size and production cost of the camera module.

The object of this invention is to provide a camera module allowing for a reduced size and lower production cost.

### SUMMARY OF THE INVENTION

The solution according to the invention lies in the features of the independent claim and preferably in those of the dependent claims.

The invention provides a camera module that comprises an image sensor chip comprising a semiconductor chip having a photoelectronic transducer formed on a surface of the semiconductor chip and a filter portion disposed on the photoelectronic transducer so as to block light incident on the filter portion at a predetermined range of wavelength, and a lens disposed above the image sensor chip.

According to the invention the filter portion serves a dual purpose, namely to filter out unwanted radiation and to provide support for the semiconductor chip. A separate glass substrate as it is provided in the prior art camera module is no longer required. Further, a separate filter portion is no longer needed. With this invention, size and cost of the camera module are reduced.

### BRIEF DESCRIPTION OF THE DRAWINGS

Fig. 1 is a cross-sectional view showing a camera module according to an embodiment of this invention.
Fig. 2 is a cross-sectional view showing a camera module according to another embodiment of this invention.
Fig. 3 is a cross-sectional view showing a conventional camera module.

### DETAILED DESCRIPTION OF THE INVENTION

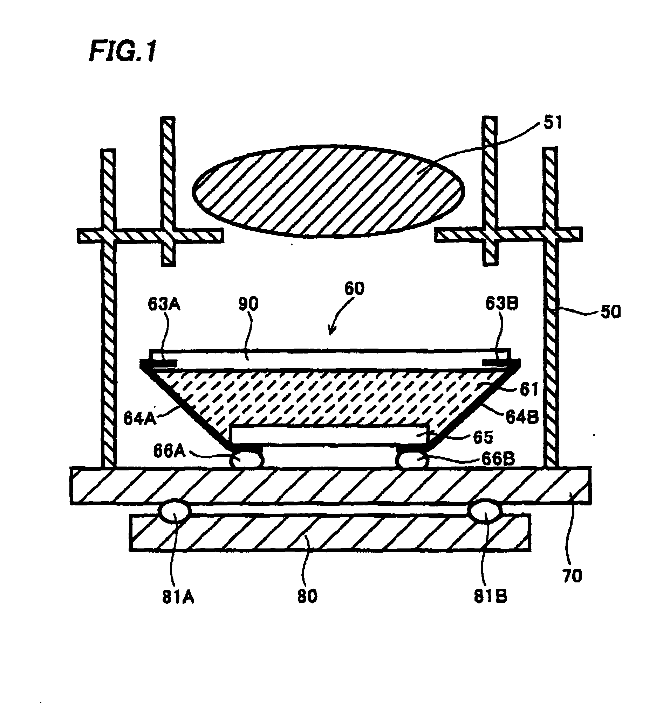

An embodiment of this invention will be described in detail, referring to the figures. Fig. 1 is a cross-sectional view showing a structure of a camera module according to the embodiment of this invention. The same symbols are assigned to the same components in Fig. 1 as in Fig.3, and explanations of them are omitted.

CCDs, which are photoelectronic transducers, are formed in a surface of a silicon chip 61 of an image sensor chip 60. An IR filter 90 is bonded to the silicon chip 61 with an adhesive to cover the CCDs. The IR filter 90 corresponds to the supporting glass substrate 62 to support the thin silicon chip 61 shown in Fig. 3, and has a filtering function in addition to a function to support the silicon chip 61. In other words, the IR filter 90 also serves as a supporting structure like the glass substrate 62 did in the prior art camera module. The IR filter 90 is obtained by vacuum deposition of metal on a glass material or incorporating copper particles into a glass material. Or, a plastic material, a surface of which has a grating structure to provide a filtering function, may be used as the IR filter 90. A single substrate provides both the filtering function and the chip-supporting function.

When forming the IR filter 90 by vacuum deposition of metal on the glass material, the vacuum deposition may be made before or after bonding the glass material to the surface of the silicon chip 61.

The IR filter 90 which blocks infrared radiation is used in an example described above. Instead, an infrared radiation pass filter, which blocks radiation other than the infrared radiation, may be used when the image sensor chip 60 is an infrared radiation image sensor chip.

Even when the function as the supporting substrate is not required, production cost can be reduced by forming the IR filter 90 on a wafer with a semiconductor wafer processing. For example, various kinds of filters (including IR filter 90) can be formed on a wafer, in which CCDs are formed, by forming a silicon oxide film (a kind of glass) by CVD (Chemical Vapor Deposition) or forming a SOG (Spin-On Glass) film (also a kind of glass) by coating, planarizing the silicon oxide film or the SOG film by CMP (Chemical Mechanical Polishing) and vacuum deposition of metal on the film.

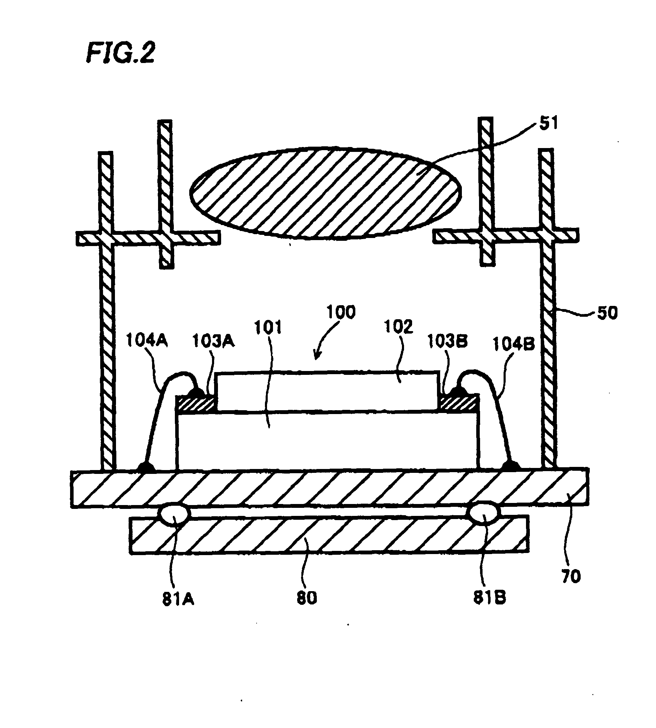

The image sensor chip 60 shown in Fig. 1 has bump electrodes 66A and 66B on its back surface. Also an image sensor chip 100 without bump electrodes as shown in Fig. 2 may be used. That is, the image sensor chip 100 has a silicon chip 101, in a surface of which CCDs are formed, IR filter 102 formed to cover the surface of the silicon chip 101 and electrode pads 103A and 103B formed on a peripheral surface of the silicon chip 101. The electrode pads 103A and 103B are connected to a printed circuit board through bonding wires 104A and 104B. The IR filter 102 is formed after the electrode pads 103A and 103B are formed by wafer processing as described above. The IR filter 102 is removed from regions on the electrode pads 103A and 103B.

With this invention, size and cost of the camera module are reduced by forming the filter material to cover the surface of the silicon chip of the image sensor chip.

## Claims

1. A camera module comprising:
- an image sensor chip (60, 100) comprising a semiconductor chip (61, 101) having a photoelectronic transducer formed on a surface of the semiconductor chip and a filter portion (90, 102) disposed on the photoelectronic transducer so as to block light incident on the filter portion (90) at a predetermined range of wavelength; and
- a lens (51) disposed above the image sensor chip (60).

2. The camera module of claim 1, wherein the filter portion (90) is configured to provide mechanical support to the semiconductor chip (60).

3. The camera module of claim 1 or 2, wherein the filter portion (90) comprises a glass plate and a metal film formed on a surface of the glass plate by vapor deposition.

4. The camera module of claim 1 or 2, wherein the filter portion (90) comprises a plastic plate and a grating formed on a surface of the plastic plate so as to provide a filtering function.

5. The camera module of claim 1 or 2, wherein the filter portion (90) comprises a glass plate doped with copper particles or a plastic plate doped with the copper particles.

6. The camera module according to any of claims 1 to 5, wherein the semiconductor chip comprises an electrode pad disposed on the surface of the semiconductor chip that does not have the photoelectronic transducer formed thereon.

7. The camera module of claim 6, wherein the image sensor chip comprises a terminal (66A, B) for external connection disposed on a back surface of the image sensor chip (60) and connected to the electrode pad.
